(19) Europäisches Patentamt
European Patent Office
Office européen des brevets

(11) **EP 3 820 046 B1**

(12) **EUROPEAN PATENT SPECIFICATION**

(45) Date of publication and mention
of the grant of the patent:
**10.09.2025 Bulletin 2025/37**

(21) Application number: **20203514.3**

(22) Date of filing: **23.10.2020**

(51) International Patent Classification (IPC):
**H03K 17/082** (2006.01)      **H03K 17/16** (2006.01)

(52) Cooperative Patent Classification (CPC):
**H03K 17/165; H03K 17/082**

(54) **DRIVING DEVICE AND DRIVING METHOD OF SEMICONDUCTOR DEVICE, AND POWER CONVERSION DEVICE**

ANSTEUERUNGSVORRICHTUNG UND ANSTEUERUNGSVERFAHREN FÜR EIN HALBLEITERBAUELEMENT UND LEISTUNGSUMWANDLUNGSVORRICHTUNG

DISPOSITIF DE COMMANDE ET PROCÉDÉ DE COMMANDE D'UN DISPOSITIF SEMICONDUCTEUR ET DISPOSITIF DE CONVERSION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.11.2019 JP 2019200506**

(43) Date of publication of application:
**12.05.2021 Bulletin 2021/19**

(73) Proprietor: **Hitachi, Ltd.**
**Tokyo 100-8280 (JP)**

(72) Inventors:
• **SUZUKI, Hiroshi**
  **Tokyo, 100-8280 (JP)**
• **SHIRAISHI, Masaki**
  **Tokyo, 100-8280 (JP)**

(74) Representative: **Strehl & Partner mbB**
**Maximilianstrasse 54**
**80538 München (DE)**

(56) References cited:
**US-A1- 2003 107 905      US-A1- 2004 145 918**

**Description**

BACKGROUND OF THE INVENTION

1. Field of the Invention

The present invention relates to a driving device and a driving method for driving a semiconductor device used in a power conversion device, and a power conversion device to which the driving device and the driving method are applied.

2. Description of the Related Art

In a main circuit of a power conversion device such as a three-phase AC inverter, two arms in which a semiconductor switching element such as an insulated gate bipolar transistor (IGBT) and a diode (reflux diode) are connected in antiparallel are connected in series.

Although a voltage of each arm changes steeply as the semiconductor switching element is driven to be on and off, an allowable voltage change rate (dv/dt) is set by a system side request, such as securing insulating properties of a load (such as a motor) to which power is supplied by the power conversion device and prevention of radiation noise.

At a time of recovery, a reverse bias voltage is applied to a diode of one arm of the two arms connected in series, that is, an upper arm on a high potential side and a lower arm on a low potential side. The reverse bias voltage increases in accordance with a decrease in a voltage of the semiconductor switching element turned on in the other arm. Here, the voltage change rate (dv/dt) of the semiconductor switching element changes in accordance with gate driving conditions (gate resistance, gate voltage, etc.). Therefore, the dv/dt of the reverse bias voltage applied to the diode in the one arm can be set in accordance with gate driving conditions of the semiconductor switching element in the other arm.

The dv/dt of the semiconductor switching element and the diode also changes depending on an operation state of the semiconductor switching element. For example, when the IGBT is turned on, the recovery dv/dt of the diode of a counter arm increases as the current flowing through the semiconductor switching element decreases, and as a temperature of the semiconductor switching element decreases. Therefore, even if the gate driving conditions are standard values, dv/dt is not reduced because of the operation state of the semiconductor switching element.

In contrast, a technique in the related art described in JP-A-2009-27881 (PTL 1) is known as a technique for controlling gate driving conditions in accordance with an operation state of a semiconductor switching element. In the technique in the related art, a conduction current Ic of the semiconductor switching element is estimated based on a current command value, and a driving speed is controlled in such a manner that, when an operation in a low current region is estimated, turning on is performed by a low-speed switch, and when an operation in a high current region is estimated, turning on is performed by a high-speed switch.

In the above related art, in the control of the driving speed, a trade-off relationship between dv/dt of the semiconductor switching element and a diode and switching loss generated when the semiconductor switching element is turned on is not fairly taken into consideration. Therefore, depending on operating conditions, it is difficult to prevent the switching loss even if the dv/dt can be reduced.

A driving circuit for a semiconductor component with the features in the pre-characterizing portion of Claim 1 is disclosed in US 2003/107905 A1.

SUMMARY OF THE INVENTION

Therefore, the invention provides a driving device and a driving method of a semiconductor device and a power conversion device that can prevent switching loss while reducing dv/dt in accordance with operating conditions.

In order to solve the above problem, the present invention suggests the driving device of a semiconductor device and the driving method of a semiconductor device defined in the respective independent claims. Further advantageous features are set out in the dependent claims.

According to the invention, even when the operation state of the semiconductor device changes, since the voltage change rate of the reflux diode is controlled to a constant value, the semiconductor device can be driven with low noise and low loss.

Problems, configurations, and effects other than those described above will be further clarified with the following description of embodiments.

BRIEF DESCRIPTION OF THE DRAWINGS

FIG. 1 is a circuit diagram showing a schematic configuration of a three-phase inverter system according to a first embodiment.

FIG. 2 is a functional block diagram showing a configuration of a gate driving device according to the first embodiment.

FIG. 3 is a flowchart showing a method of acquiring an optimum gate current data set.

FIG. 4 is a configuration diagram of a device for acquiring the optimum gate current data set.

FIG. 5 is a graph showing an example of a tradeoff relationship between a turn-on loss of an IGBT and a voltage change rate during reverse recovery of a reflux diode.

FIG. 6 is a circuit diagram showing a configuration of an analog output unit that outputs a gate current to the IGBT according to the first embodiment.

FIG. 7 is a circuit diagram showing a configuration of an analog output unit provided in a gate driving device in a three-phase inverter system according to a second embodiment.

FIG. 8 is a circuit diagram showing a schematic configuration of a three-phase inverter system according to a third embodiment.

## DESCRIPTION OF THE PREFERRED EMBODIMENTS

Hereinafter, as for embodiments of the invention, a first embodiment to a third embodiment will be described with reference to the drawings. In the drawings, the same reference numerals denote the same constituent elements or constituent elements having similar functions.

[Embodiment 1]

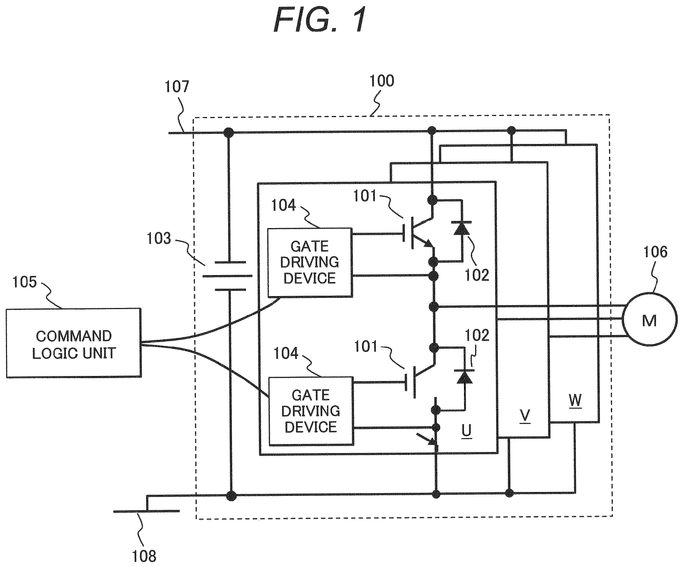

FIG. 1 is a circuit diagram showing a schematic configuration of a three-phase inverter system according to the first embodiment of the invention.

In the three-phase inverter system, a power unit 100 includes IGBTs 101 and a filter capacitor 103. In each of UVW phases, two IGBTs 101 are connected in series, and reflux diodes 102 are connected in parallel to corresponding IGBTs 101 in a manner that current directions thereof are reversed to each other. That is, in each phase, a pair of upper and lower arms are connected in series, and a series connection circuit of the arms is connected in parallel to the filter capacitor 103. A gate driving device 104 that drives each IGBT 101 according to a command signal from a command logic unit 105 is connected to a gate of each IGBT 101.

A series connection point between the IGBT 101 on the upper arm and the IGBT 101 on the lower arm of each of the UVW phases is connected to a motor 106, which is a load, as an output of the power unit 100. A high potential side of the filter capacitor 103 is connected to a DC power supply potential 107. A low potential side of the filter capacitor 103 is connected to a ground potential 108. The pair of upper and lower arms connected in series are connected between the DC power supply potential 107 and the ground potential 108.

The three-phase inverter system performs on and off switching of the IGBTs 101 of the UVW phases in the power unit 100, thereby converting DC power input from a DC power supply (not shown) to a DC side (filter capacitor 103 side) of the power unit 100 into three-phase AC power, and outputting the three-phase AC power to the motor 106.

The gate driving devices 104 disposed in the power unit 100 together with the IGBTs 101 and the filter capacitor 103 drive the IGBTs 101 in accordance with the command signal from the command logic unit 105. The command logic unit 105 includes a calculation device, a memory, and an input and output unit, creates a command signal for driving the IGBTs 101 by executing a predetermined program, and outputs the command signal to the gate driving devices 104.

A semiconductor switching element driven by the gate driving device 104 is not limited to an IGBT, and may be a voltage-driven semiconductor switching element such as a MOSFET. A semiconductor forming the semiconductor switching element may be silicon (Si), or may be a wide-gap semiconductor (silicon carbide (SiC), gallium nitride (GaN), or the like).

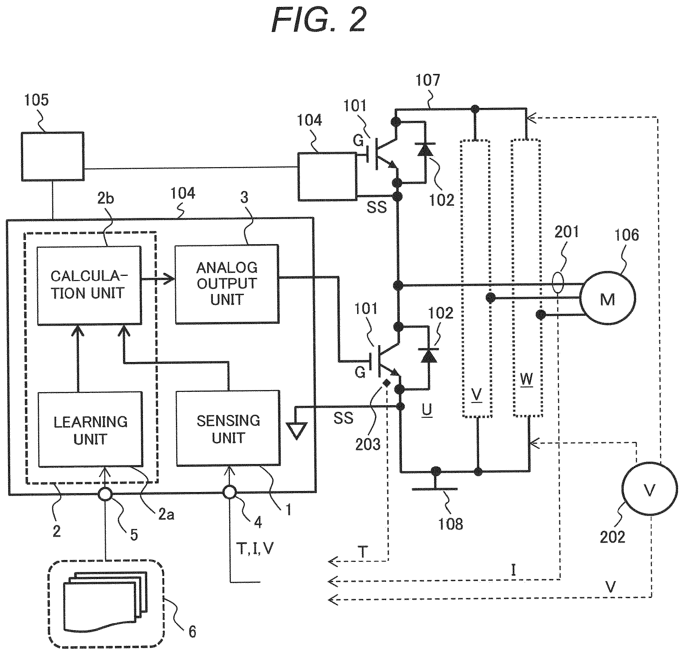

FIG. 2 is a functional block diagram showing a configuration of a gate driving device according to the first embodiment. Although only the lower arm of the U-phase in the three-phase inverter system shown in FIG. 1 is illustrated in FIG. 2, gate driving devices of the upper arm of the U-phase and the upper and lower arms of the V-phase and the W-phase have similar configurations. Therefore, although the configuration and an operation of the gate driving device of the lower arm of the U-phase will be described below, a configuration and an operation of the other gate driving devices are also similar.

The gate driving device 104 is connected to a gate terminal G of the IGBT 101 and a sense emitter terminal (auxiliary emitter terminal) SS. The gate driving device 104 is connected to the upper-level command logic unit 105.

As shown in FIG. 2, the gate driving device 104 includes a sensing unit 1, a digital control unit 2, and an analog output unit 3. The digital control unit 2 includes a learning unit 2a and a calculation unit 2b.

A drive command signal is input from the command logic unit 105 to the gate driving device 104. While the drive command signal is input, the gate driving device 104 applies a voltage (for example, +15 V) exceeding a gate threshold voltage of the IGBT 101 between the gate and the emitter (between G and SS) of the IGBT 101, and turns on the IGBT 101 to allow a current to flow to the IGBT 101 (turn on). While the drive command signal is not input from the command logic unit 105, the gate driving device 104 applies a voltage (for example, -10 V) below the gate threshold voltage between the gate and the emitter (between G-SS) of the IGBT 101, and turns off the IGBT 101 to block the current of the IGBT 101 (turn off).

The gate driving device 104 senses an operation state of the IGBT 101, that is, a current I flowing in the IGBT 101, a voltage V applied to the IGBT 101 (In FIG. 2, a voltage between both ends of the filter capacitor 103 (FIG. 1)), and a temperature T of the IGBT 101 with a current sensor 201, a voltage sensor 202, and a temperature sensor 203, respectively. Sensing information (I, V, T) is input to the sensing unit 1. The sensing unit 1 receives the sensing information via an analog signal input unit 4, converts the sensing information into a digital signal, and sends the converted sensing information to the calculation unit 2b.

The gate driving device 104 according to the first embodiment inputs a piece of information or a plurality of pieces of information among any one of I, V, and T, and outputs, in accordance with the input information, a gate current that controls the magnitude of the dv/dt of the reflux diode to a constant value, as will be described later.

As the current sensor 201, a current probe (current transformer (CT), a Rogowski coil, or the like), or a shunt resistor is applied. An estimated value of the current flowing through the IGBT 101 may be calculated from a measured value of a load current flowing through the motor 106.

The voltage sensor 202 may directly detect a voltage between a collector and the emitter of the IGBT 101, in addition to detecting a voltage between both ends of the filter capacitor 103.

For example, a thermistor or the like is used as the temperature sensor 203. An estimated value of the temperature of the IGBT 101 may be calculated from measured values of electrical characteristic parameter temperature sensitive electrical parameters (TSEP) of a semiconductor element that change in accordance with the temperature, such as an on-voltage of the IGBT 101.

The learning unit 2a acquires a learning data set 6 via a data input unit 5, and sends a learning result (for example, a linear model) to the calculation unit 2b.

Based on the sensing information (I, V, T) and the learning result, the calculation unit 2b calculates a gate current ($I_g$) that controls the magnitude of the dv/dt of the reflux diode to a constant value, that is, an optimum gate current, and sends a gate current output command in accordance with the calculated value to the analog output unit 3.

The analog output unit 3 outputs the optimum gate current $I_g$ to the gate terminal G of the IGBT 101 based on the gate current output command from the calculation unit 2b, and drives (turns on or turns off) the IGBT 101.

Hereinafter, an operation of the gate driving device 104 will be described.

Hereinafter, a method for acquiring a data set of the optimum gate current ($I_g$) and a method for learning the linear model used for $I_g$ calculation from the data set will be described, in which the gate driving device 104 is applied for calculating and outputting the optimum gate current based on the operation state of the IGBT 101 at a current time point so that the magnitude of the voltage change rate (dv/dt) during reverse recovery of the reflux diode is a predetermined constant value even if operating conditions (voltage V, current I, and temperature T) change. The acquisition of the optimum gate current data set and the learning of the linear model based on the acquired data set are executed for each IGBT 101. Hereinafter, although a case of the IGBT of the U-phase lower arm will be described, the IGBT of the U-phase upper arm, IGBTs of the V-phase and the W-phase upper and lower arms are also similar.

First, the method for acquiring a data set of the optimum gate current ($I_g$) will be described.

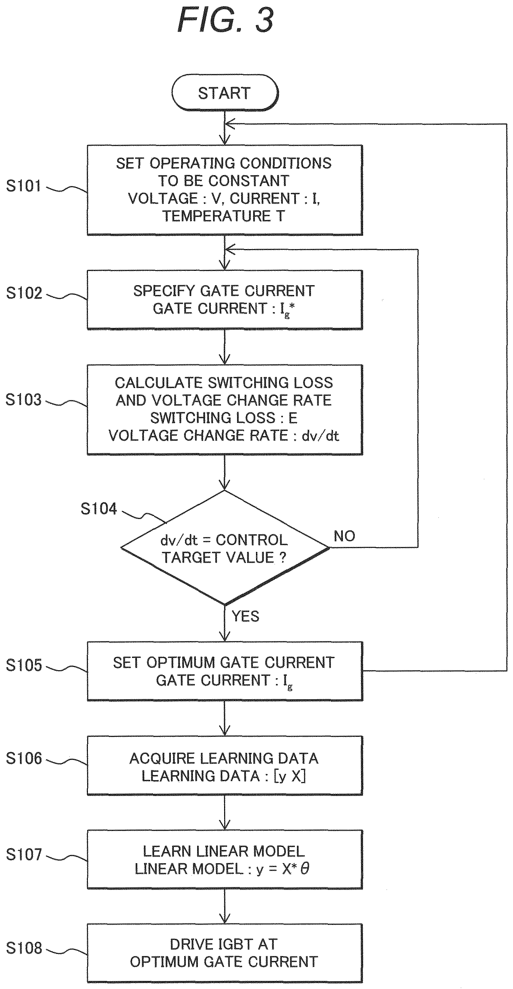

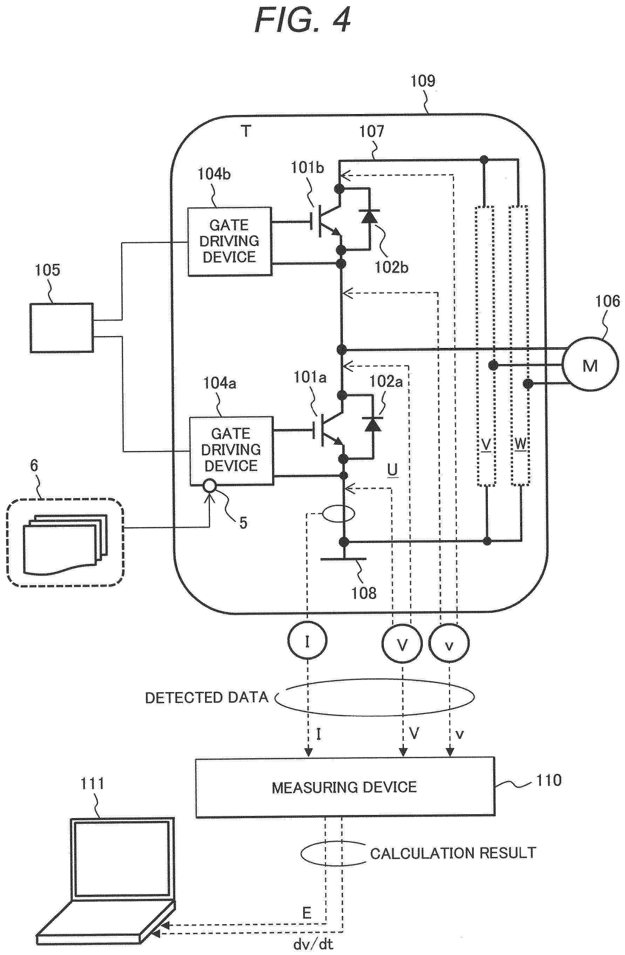

FIG. 3 is a flowchart showing a method of acquiring the optimum gate current data set. FIG. 4 is a configuration diagram of a device for acquiring the optimum gate current data set. Each step in FIG. 3 will be described with reference to the device configuration in FIG. 4.

First, in step S101 (FIG. 3), the operating conditions (voltage V, current I, temperature T) of an IGBT 101a (FIG. 4) are constant. Here, it is assumed that V, I, and T are constant as V1, I1, and T1, respectively.

In this case, the voltage V1 is set by an external power supply (not shown) so that a voltage value between the power supply potential 107 and the ground potential 108 is V1. As shown in FIG. 4, the temperature T1 is set by inserting the entire three-phase inverter system (main circuit and gate driving device) into a thermostatic tank 109 set at the temperature T1. Since the current I1 increases in proportion to a time when the IGBT 101a is turned on and the current flows, that is, an input time of the drive command signal to a gate driving device 104a, the current I1 is set by controlling the input time so that the current flowing through the IGBT 101a is I1.

Next, in step S102 (FIG. 3), the gate driving device 104a (FIG. 4) specifies a gate current value ($I_g*1$) to be output to the IGBT 101a. In the first embodiment, the gate driving device 104a sets $I_g*1$ as a gate current value to be output to the IGBT 101a with a setting signal from an external device via the data input unit 5. At the time of acquiring the optimum gate current data set, the gate driving device 104a outputs a gate current according to the set gate current value ($I_g*1$) to the gate terminal of the IGBT 101a.

The gate current value $I_g*1$ may be rewritable by external software as program data to the digital control unit 2 (FIG. 2). As such a software rewriting method, a field programmable gate array (FPGA) may be applied as the digital control unit 2, and a program specifying the gate current value $I_g*1$ may be compiled via the data input unit 5. Accordingly, when the gate current value ($I_g$*1) to be output to the IGBT 101a is set, since a hardware change such as a change in the output gate resistance of the gate driving device 104 is reduced, the data set can be efficiently acquired.

Next, in step 103 (FIG. 3), the IGBT 101a is driven at the gate current value $I_g$*1 by the gate driving device 104a, and switching (turning on) loss (E) of the IGBT 101a at this time and the voltage change rate (dv/dt) during the reverse recovery of a reflux diode 102b on the counter arm are acquired. At this time, the other IGBTs are similarly driven, and the three-phase inverter system operates.

In the step 103 (FIG. 3), as shown in FIG. 4, a voltage (V) between a collector and an emitter of the IGBT 101a and a voltage (v) between a cathode and an anode of the reflux diode 102b on the counter arm are detected by, for example, a high-voltage probe, and voltage detection values are input to a measuring device 110 (for example, a digital oscilloscope) having a calculation function. The current (I) flowing through the IGBT 101a is detected by, for example, a current probe or a current transformer, and a current detection value is input to the measuring device 110. The measuring device 110 calculates, by time-integrating a power value (integrated value of V and I), a turn-on loss (E) of the IGBT 101a from a waveform of the voltage (V) between the collector and the emitter and a waveform of the current (I) when the IGBT 101a is turned on, and outputs a calculated value (E1) to a processing device 111. The measuring device 110 calculates a voltage change rate (dv/dt) from the waveform of the voltage (v) between the cathode and the anode of the reflux diode 102b, and outputs a calculated value ((dv/dt)1) to the processing device 111. Accordingly, at one operating condition (voltage V1, current I1, temperature T1) of the IGBT 101a, the turn-on loss value (E1) of the IGBT 101a and the voltage change rate value ((dv/dt) 1) of the reflux diode 102b relating to the gate current value $I_g$*1 of the IGBT 101a are acquired.

The processing device 111 is a computer (for example, a personal computer), and includes a display device.

Since a trade-off relationship exists between the turn-on loss (E) and the voltage change rate (dV/dt) of the IGBT 101a, a trade-off relationship also exists between the voltage change rate (dv/dt) of the reflux diode 102b that performs the reverse recovery with the turn on of the IGBT 101a and the turn-on loss (E) of the IGBT 101a.

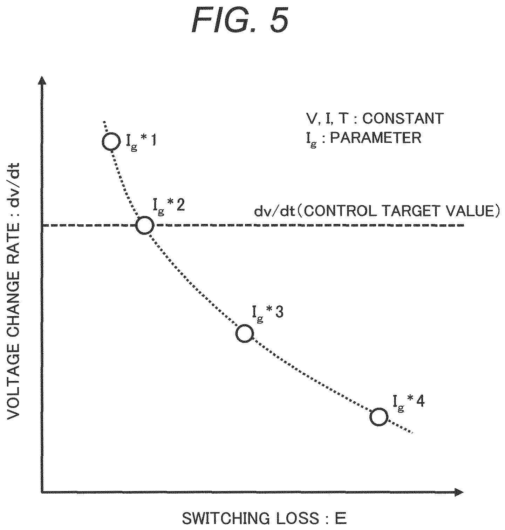

FIG. 5 is a graph showing an example of the tradeoff relationship between the switching loss (turn-on loss) E of the IGBT 101a and the voltage change rate dv/dt during the reverse recovery of the reflux diode 102b. V, I, and T are constant (V = V1, I = I1, t = T1), and the gate current $I_g$ is used as a parameter.

The processing device 111 displays a graph as shown in FIG. 5 on the display device included in the processing device 111 based on the calculated value of the turn-on loss E and the calculated value of the voltage change rate acquired from the measuring device 110. As shown in the graph, E and dv/dt indicate a trade-off relationship. At a time point when V, I, and T are constant as V1, I1, and T1, and step S103 (FIG. 3) is executed as $I_g = I_g$*1, only plots corresponding to $I_g$*1 in FIG. 5 are displayed on the display device of the processing device 111.

Next, in step S104, the processing device 111 determines whether the calculated value of dv/dt ((dv/dt)1) acquired in step S103 matches a control target value (dv/dt_target). If the values match (Yes), step S105 is executed next, and if the values do not match (No), the processing returns to step S102, and another gate current value ($I_g$*2) is set, and steps S102 to S104 are executed again.

The control target value (dv/dt_target) is set in accordance with a request on a motor drive system side, such as securing insulation properties of the motor 106 supplied with power by the three-phase inverter system, and preventing radiation noise.

In step S105, when it is determined in step S104 that (dv/dt)1 relating to $I_g$*1 matches dv/dt_target, $I_g$*1 is set to an optimum gate current ($I_g$1) relating to the operating conditions (V1, I1, T1) ($I_g$1 = $I_g$*1). If it is determined in step S104 that (dv/dt) 1 does not match dv/dt_target and that (dv/dt)2 relating to $I_g$*2 matches dv/dt_target as a result of $I_g = I_g$* 2 and executing steps S102 to S104 again, the processing device 111 sets $I_g$*2 to the optimum gate current ($I_g$1) relating to the operating conditions (V1, I1, temperature T1) ($I_g$1=$I_g$*2).

FIG. 5 described above indicates that the dv/dt relating to $I_g$*2 matches the control target value.

In step S105, when the optimum gate current relating to the operating conditions (voltage V1, current I1, temperature T1) is set, next, step S101 to step S105 for setting other operating conditions to be constant are repeated, so as to set the optimum gate current $I_g$2 relating to the operating conditions (voltage V2, current I2, temperature T2).

In this manner, steps S101 to S105 are repeatedly executed while changing the operating conditions only by the number (n) of data samples used for learning. Accordingly, in step S106, n optimum gate currents ($I_g$k) corresponding to the operating conditions (voltage Vk, current Ik, temperature Tk) are acquired (k = 1, 2, ···, n). For example, a data set including 27 data samples is acquired when the data set is acquired while changing the operating conditions by one of the three conditions of the voltage, the current, and the temperature once at a time.

Here, the data set is represented by an input X shown in an Equation (1) and an output y shown in Equation (2).

As shown in the Equation (1), the input X is an operating condition, and is represented by an $n \times 4$ matrix in which a first column is a constant 1, a second column is a voltage Vk, a third column is a current Ik, a fourth column is a temperature Tk, and rows of the number n of data samples are arranged vertically.

As shown in the Equation (2), an output y is an optimum gate current ($I_g$k) so that the voltage change rate (dv/dt) of the reflux diode matches the control target value (dv/dt_target) under each operating condition, and is represented by an $n \times 1$ matrix (column vector) in which rows of the number n of the data samples are arranged vertically.

$$X = \begin{bmatrix} 1 & V1 & I1 & T1 \\ 1 & V2 & I2 & T2 \\ \cdot & \cdot & \cdot & \cdot \\ \cdot & \cdot & \cdot & \cdot \\ \cdot & \cdot & \cdot & \cdot \\ 1 & Vn & In & Tn \end{bmatrix} \quad \cdots \quad (1)$$

$$y = \begin{bmatrix} Ig1 \\ Ig2 \\ \cdot \\ \cdot \\ \cdot \\ Ign \end{bmatrix} \quad \cdots \quad (2)$$

Next, the method for learning a linear model used for $I_g$ calculation from a data set will be described. The method corresponds to step S107 in FIG. 3.

A set [y X] of the data sets y and X described above is set as the learning data set 6 (FIG. 4), and the learning data set 6 is input from the data input unit 5 to the learning unit 2a in the digital control unit 2 (FIG. 2). The learning data set 6 may be input to the learning unit 2a by external software as program data to the learning unit 2a. In this case, for example, the FPGA is applied as the learning unit 2a, and a program in which the learning data set [y X] is stored is compiled from the data input unit 5.

The learning unit 2a inputs the learning data set [y X] and performs learning to output a linear model shown in an Equation (3). "θ" in the Equation (3) is represented by a $4 \times 1$ matrix (column vector) including parameters θ0 to θ3 shown in an Equation (4).

$$y = X * \theta \quad \cdots \quad (3)$$

$$\theta = \begin{bmatrix} \theta 0 \\ \theta 1 \\ \theta 2 \\ \theta 3 \end{bmatrix} \quad \cdots \quad (4)$$

That is, in the first embodiment, the learning unit 2a performs a multiple regression analysis for obtaining the coefficient parameter θ of the linear model most suitable for the data set [y X]. For example, the learning unit 2a learns a linear model of, by the multiple regression analysis, expressing the gate current $I_g$ by a linear sum of three feature amounts of the voltage V, the current I, and the temperature T representing the operation state of the IGBT as shown in an Equation (5).

$$Ig = \theta 0 + \theta 1 * V + \theta 2 * I + \theta 3 * T \quad \cdots \quad (5)$$

In the linear model, only any one or two of the V, I, and T may be used as the feature amount. A power term ($I^2$, for example) of the feature amount may be included.

The learning unit 2a sends the linear model (Equation (5)) learned in step S107 to the calculation unit 2b (FIG. 2). During operation of the three-phase inverter system, the sensing unit 1 (FIG. 2) acquires the operation state (voltage V, current I, temperature T) of the IGBT 101, and sends it to the calculation unit 2b. The calculation unit 2b calculates a gate current ($I_g$) by using the acquired operation state (voltage V, current I, temperature T) and a linear model (Equation (5)), and sends a gate current output command in accordance with the calculated value of $I_g$ to the analog output unit 3 (FIG. 2). The analog output unit 3 outputs the gate current to the gate terminal of the IGBT 101 based on the gate current output command from the calculation unit 2b, and drives the IGBT 101 (Step S108 in FIG. 3).

Accordingly, even when the operation state (V, I, T) of the IGBT 101 changes, the gate driving device 104 (FIG. 2) can drive the IGBT 101 with the optimum gate current that prevents the occurrence of turn-on loss while reducing the dv/dt during the reverse recovery of the reflux diode on the counter arm to the control target value (dv/dt_target).

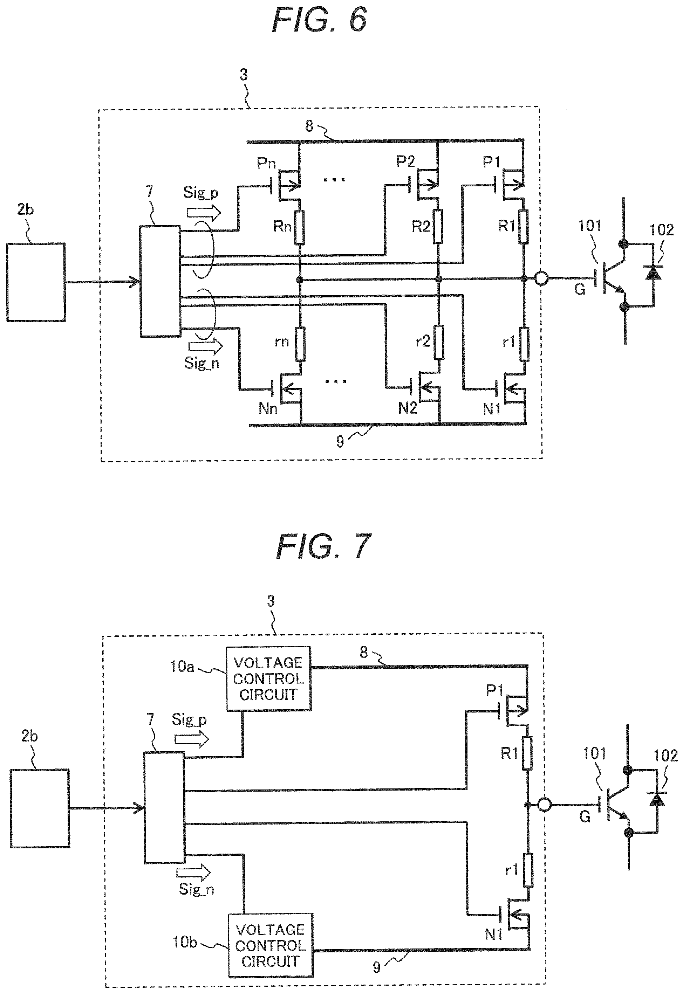

FIG. 6 is a circuit diagram showing a configuration of an analog output unit 3 (FIG. 2) that outputs a gate current to the IGBT 101 in the first embodiment.

As shown in FIG. 6, the analog output unit 3 includes a signal distributor 7, a plurality of (n) p-channel MOSFETs (hereinafter, referred to as "PMOS") that form an output stage of an on-gate circuit, the same number as the PMOSs of (n) gate resistances (hereinafter, referred to as "on-gate resistance"), a plurality of (n) n-channel MOSFETs (hereinafter referred to as "NMOS") that form an output stage of an off-gate circuit and the same number as the NMOSs of (n) gate resistances (hereinafter referred to as "off-gate resistance").

Source terminals of the PMOSs P1, P2, $\cdots$, Pn are connected to a positive-side power supply potential 8 for the gate driving device 104. Drain terminals of the PMOSs P1, P2, $\cdots$, Pn are connected to one ends of the on-gate resistances R1, R2, $\cdots$, Rn, respectively. The other ends of the on-gate resistances R1, R2, $\cdots$, Rn are connected to the gate G of the IGBT 101.

Source terminals of the NMOSs N1, N2, $\cdots$, Nn are connected to a negative-side power supply potential 9 for the gate driving device 104. Drain terminals of the NMOSs N1, N2, $\cdots$, Nn are connected to one ends of the off-gate resistances r1, r2, $\cdots$, rn, respectively. The other ends of the off-gate resistances r1, r2, $\cdots$, rn are connected to the gate G of the IGBT 101.

An input unit of the signal distributor 7 is connected to the calculation unit 2b. 2n output units of the signal distributor 7 are connected to (2n) gates of the n PMOSs and the n NMOSs.

The calculation unit 2b sends gate current output commands (Sig_p and Sig_n) in accordance with the calculated value of the gate current $I_g$ to the signal distributor 7. The signal distributor 7 distributes the gate current output commands (Sig_p and Sig_n) to the PMOSs and the NMOSs.

Each of Sig_p and Sig_n is an n-bit digital signal (1 or 0), the signal "1" represents setting the MOSFET in the output stage to on, and the signal "0" represents setting the MOSFET in the output stage to off. The Sig_p specifies a PMOS to be set to be on among the PMOS P1, P2, $\cdots$, Pn when the IGBT 101 is turned on. That is, a signal of a k-th bit of the Sig_p specifies on and off of a PMOS Pk (k = 1, 2, $\cdots$, n). The Sig_n specifies an NMOS to be set to be on among the NMOS N1, N2, $\cdots$, Nn at the time when the IGBT 101 is turned off. That is, a signal of a k-th bit of the Sig_n specifies on and off of an NMOS Nk (k = 1, 2, $\cdots$, n).

The signal distributor 7 distributes the signal of the k-th bit of the Sig_p to the PMOS Pk. Accordingly, the PMOSs specified to be turned on by the Sig_p is connected in parallel via the on-gate resistances. In other words, the on-gate resistances connected in series to the PMOSs specified to be turned on are connected in parallel via the PMOSs. A magnitude of an on-gate current is set in accordance with the PMOSs and the on-gate resistances connected in parallel.

The signal distributor 7 distributes the signal of the k-th bit of the Sig_n to the NMOS Nk. Accordingly, the NMOSs specified to be turned on by the Sig_n is connected in parallel via the off-gate resistance. In other words, the off-gate resistances connected in series to the NMOSs specified to be turned on are connected in parallel via the NMOSs. A magnitude of an off-gate current is set in accordance with the NMOSs and the off-gate resistances connected in parallel.

For example, when the number of the PMOSs in the output stage is four (n = 4), Sig_p is a 4-bit digital signal. When such a 4-bit Sig_p is "0001", only P1 is turned on. Therefore, a parallel number of the PMOS and the on-gate resistance is "1", and a magnitude of the on-gate current output from the analog output unit 3 is a minimum value. When the 4-bit Sig_p is "1111", all P1 to P4 are turned on. Therefore, the parallel number of the PMOS and the on-gate resistance is "4", and the magnitude of the on-gate current is a maximum value. When the 4-bit Sig_p is "0011", P1 and P2 are turned on, and P3 and P4 are turned off. Therefore, the parallel number of the PMOS and the on-gate resistance is "2", and the magnitude of the on-gate current is an intermediate value.

In this manner, the magnitude of the gate current output from the analog output unit 3 can be controlled by changing the parallel number of the MOSFET and the gate resistance in the output stage in accordance with the value of the gate current output command (Sig_p or Sig_n). Therefore, the analog output unit 3 can output the optimum gate current to the gate G of the IGBT 101 in a manner of preventing the occurrence of turn-on loss while reducing the dv/dt during the reverse recovery of the reflux diode of the counter arm of the IGBT 101 to the control target value (dv/dt_target) in accordance with the operation state of the IGBT 101.

The first embodiment is similarly applied to a case where the IGBT of the upper arm is turned on and the reflux diode of the lower arm performs the reverse recovery (other embodiments are similar).

As described above, according to the first embodiment, the voltage change rate (dv/dt) and switching loss (turn-on loss) of the diode can be reduced in a well-balanced manner by controlling the gate current so as to set the voltage change rate (dv/dt) during the reverse recovery of the diode to match the constant control target value even when the operating conditions (voltage V, current I, temperature T) of the IGBT change. For example, inconvenience such as an excessive reduction of the dv/dt leads to an increase in the switching loss (turn-on loss), or the dv/dt is not fairly reduced as a result of giving priority to reducing the switching loss (turn-on loss), and such defects will not occur.

According to the driving device according to the first embodiment, the gate driving device can drive the IGBT forming the arm with low loss and low noise. Therefore, a semiconductor device such as a power module including a parallel connection circuit of the arm, that is, the IGBT and the reflux diode, can be driven with low loss and low noise. Further, a power conversion device such as a three-phase inverter including a plurality of arms can be reduced in loss and in noise.

[Second Embodiment]

FIG. 7 is a circuit diagram showing a configuration of an analog output unit provided in a gate driving device in a three-phase inverter system according to a second embodiment of the invention. The configuration other than the analog output unit is similar as that according to the first embodiment. Hereinafter, differences from the first embodiment (FIG. 6) will be described.

As shown in FIG. 7, the analog output unit 3 in the second embodiment includes the signal distributor 7, the p-channel MOSFET (hereinafter, referred to as "PMOS") P1 that forms an output stage of an on-gate circuit, the on-gate resistance R1 that is connected in series to the P1 and the PMOS P1, a voltage control circuit 10a on an on-gate circuit side, the n-channel MOSFET (hereinafter, referred to as "NMOS") N1 that forms an output stage of an off-gate circuit, the off gate resistance r1 that is connected in series to the N1 and the NMOS N1, and a voltage control circuit 10b on an off-gate circuit side.

A source terminal of the PMOS P1 is connected to the positive-side power supply potential 8 for the gate driving device 104. A drain terminal of the PMOS P1 is connected to one end of the on-gate resistance. The other end of the on-gate resistance R1 is connected to the gate G of the IGBT 101.

A source terminal of the NMOS N1 is connected to the negative-side power supply potential 9 for the gate driving device 104. A drain terminal of the NMOS N1 is connected to one end of the off-gate resistance r1. The other end of the off-gate resistance r1 is connected to the gate G of the IGBT 101.

An input unit of the signal distributor 7 is connected to the calculation unit 2b. Four output units of the signal distributor 7 are connected to the voltage control circuit 10a, the voltage control circuit 10b, a gate of the PMOS P1, and a gate of the NMOS N1.

The voltage control circuit 10a is connected between the output unit of the signal distributor 7 and the positive-side power supply potential 8, and controls a magnitude of the positive-side power supply potential 8.

The voltage control circuit 10b is connected between the output unit of the signal distributor 7 and the negative-side power supply potential 9, and controls a magnitude of the negative-side power supply potential 9.

The calculation unit 2b sends gate current output commands (Sig_p and Sig_n) in accordance with a calculated value of the gate current $I_g$ to the signal distributor 7. The signal distributor 7 distributes the gate current output commands Sig_p and Sig_n to the voltage control circuit 10a and the voltage control circuit 10b, respectively, and distributes on and off control information of the PMOS P1 and the NMOS N1 included in the gate current output commands (Sig_p, Sig_n) to the PMOS P1 and the NMOS N1. The voltage control circuit 10a controls the magnitude of the positive-side power supply potential 8 in accordance with the gate current output command Sig_p from the signal distributor 7. The voltage control circuit 10b controls the magnitude of the negative-side power supply potential 9 in accordance with the gate current output command Sig_n from the signal distributor 7.

In the second embodiment, different from the first embodiment, the gate current output from the analog output unit 3 to the gate G of the IGBT 101 is controlled by changing the magnitude of a voltage applied to the PMOS P1 and the NMOS N1 in the output stage, as will be described below.

The calculation unit 2b sends the gate current output commands (Sig_p and Sig_n) to the signal distributor 7. Each of the Sig_p and Sig_n is an n-bit digital signal (1 or 0), and the magnitude of the value of the gate current output command corresponds to the magnitude of the power supply voltage of the gate driving device 104.

For example, when a 4-bit gate current output command is applied, the voltage control circuit 10a controls the magnitude of the positive-side power supply potential 8 in 16 stages from Sig_p = 0000 to Sig_p = 1111 when the IGBT 101 is turned on. When Sig_p = 0000, since the magnitude of the positive-side power supply potential 8 is the minimum (zero), the magnitude of the on-gate current to be output from the analog output unit 3 to the gate terminal G of the IGBT 101 is the minimum (zero). When Sig_p = 1111, since the magnitude of the positive-side power supply potential 8 is the maximum, the magnitude of the on-gate current to be output is the maximum. When Sig_p = 0000 and Sig_p ≠ 0000, the signal distributor 7 distributes off control information (off-gate signal) and on control information (on-gate signal) to the PMOS P1, respectively. When Sig_p ≠ 0000, Sig_n = 0000 is set, and the off control information (off-gate signal) is distributed to the NMOS _N1.

Similarly, when turning off, the voltage control circuit 10b adjusts the magnitude of the negative-side power supply potential 9 in accordance with the value of the gate current output command (Sig_n), thereby controlling the magnitude of the off-gate current output to the gate terminal G of the IGBT 101. Accordingly, when the IGBT 101 is turned off, the voltage change rate of the IGBT 101 and the reflux diode 102 can be controlled.

According to the second embodiment, since the number of the PMOS and the NMOS as switching elements in the output stage of the gate driving device can be reduced, the circuit of the gate driving device can be simplified, and the gate driving device can be downsized.

[Third Embodiment]

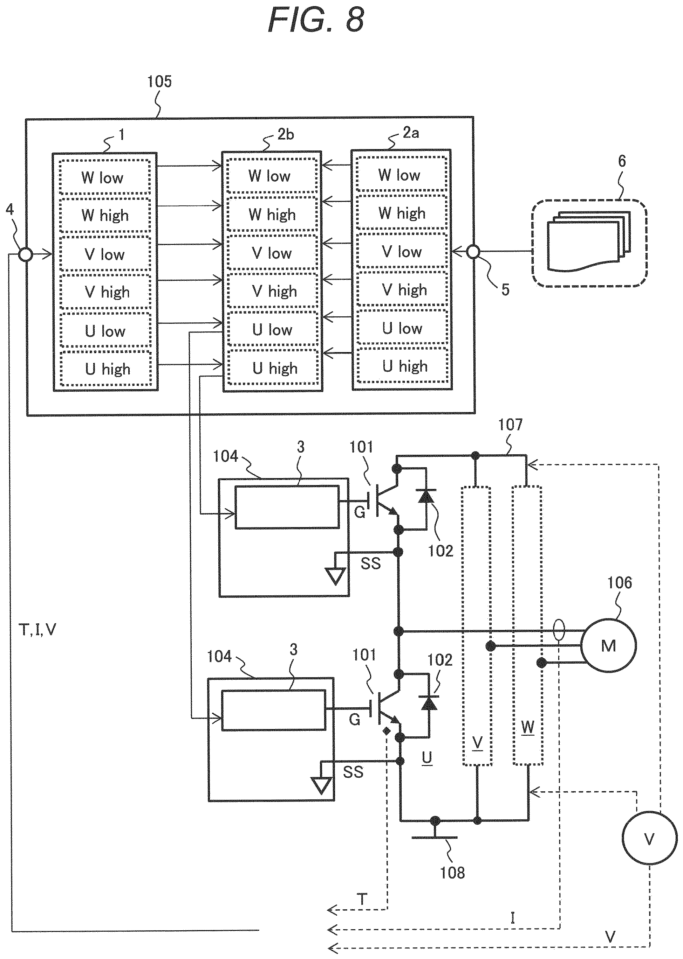

FIG. 8 is a circuit diagram showing a schematic configuration of a three-phase inverter system according to the third embodiment of the invention. Hereinafter, differences from the first embodiment and the second embodiment will be mainly described.

In the third embodiment, the sensing unit 1 and the digital control unit 2 (the learning unit 2a and the calculation unit 2b) included in the gate driving device 104 in the first embodiment (FIG. 2) are included in the command logic unit 105.

As shown in FIG. 8, the sensing unit 1 is provided with memory regions (U high, U low, V high, V low, W high, W low) that store sensing information (voltage V, current I, temperature T) of all phases and all arms (U-phase upper arm, U-phase lower arm, V-phase upper arm, V-phase lower arm, W-phase lower arm, and W-phase lower arm) in the inverter system. The sensing information (voltage V, current I, temperature T) of all phases and all arms input to the sensing unit 1 via the analog signal input unit 4 is converted into digital signals, and then is stored in corresponding storage regions, and is sent to the calculation unit 2b having a corresponding memory region.

In the third embodiment, similar as in the first embodiment, the set [y X] of the data sets y, X (refer to Equations (1) and (2)) is set as the learning data set 6, and the learning data set 6 for all phases and all arms is input from the data input unit 5 to the learning unit 2a. The input learning data set 6 is stored in the memory regions (U high, U low, V high, V low, W high, W low) of the corresponding phases and arms.

The learning data set 6 may be input to the learning unit 2a by external software as program data to the learning unit 2a. In this case, for example, the FPGA is applied as the learning unit 2a, and a program in which the learning data set [y X] is stored is compiled from the data input unit 5.

The learning unit 2a included in the command logic unit 105 learns a linear model represented by the above Equation (5) for the IGBT 101 and the reflux diode 102 of each phase and each arm similarly as in the first embodiment, based on the input learning data set 6. The learning unit 2a stores the linear model obtained by the learning in a memory region (U high, U low, V high, V low, W high, W low) of the corresponding phase and arm in the calculation unit 2b.

The calculation unit 2b calculates a gate current ($I_g$) by using the sensing information, that is, an operation state (voltage V, current I, temperature T) of the IGBT 101 acquired from the sensing unit 1 and the linear model (Equation (5)), and sends a gate current output command in accordance with the calculated value of $I_g$ to the analog output unit 3 of the gate driving device 104 in the corresponding phase and arm (FIG. 2). Although only the U-phase upper arm and the U-phase lower arm are illustrated in FIG. 8, a similar manner applies to the other arms.

The analog output unit 3 outputs the gate current to the gate terminal G of the IGBT 101 based on the gate current output command from the calculation unit 2b, and drives the IGBT 101.

According to the third embodiment, since the input of the sensing information and the learning data set are aggregated into the command logic unit 105, the number of input interfaces of the gate driving device can be reduced, and the gate driving device can be downsized. Since the sensing information of semiconductor devices (the IGBT 101 and the reflux diode 102) of each phase and each arm can be collectively managed and relatively compared in the command logic unit, the state of the entire three-phase inverter system can be monitored by the command logic unit 105.

The invention is not limited to the embodiments described above, and includes various modifications. For example, the embodiments described above have been described in detail for easy understanding of the invention, and are not necessarily limited to those including all the configurations described above. A part of the configuration of each embodiment may be added to, deleted from, or replaced with another configuration.

For example, each of the above-described embodiments is applicable not only to the three-phase inverter system but also to a power conversion device including a pair of upper and lower arms.

The pair of upper and lower arms may be configured by a power semiconductor module (1 in 1, 2 in 1, or the like) in which a single arm or a plurality of arms are stored in a case and an electrode terminal is drawn out of the case. A gate driving device may be stored in the power semiconductor module in addition to the arm.

The semiconductor switching element constituting the arm is not limited to the IGBT, and may be a power MOSFET. In this case, a parasitic diode (body diode) of a power MOSFET may be used as the reflux diode. As the reflux diode, various kinds of diodes can be used, such as a pn junction diode, a Schottky barrier diode, and a diode using a pn junction and a Schottky junction.

**Claims**

1. A driving device of a semiconductor device for driving the semiconductor device (101) serving as an arm in a power conversion device (100), the driving device comprising:

   a calculation unit (2b) configured to create, in accordance with operation state sensing information of the semiconductor device, a control current command, the operation sensing information constituted by a sensed current flowing in the semiconductor device, a sensed voltage applied to the semiconductor device and a sensed temperature of the semiconductor device, and

an output unit (3) configured to output a control current to a control terminal (G) of the semiconductor device by controlling the magnitude of the control current in accordance with the control current command, **characterized in that** the calculation unit is configured to create, in accordance with the operation state sensing information of the semiconductor device and based on a linear model, the control current command such that a magnitude of a voltage change rate of the voltage between the cathode and the anode of a reflux diode (102) in the arm during reverse recovery of the reflux diode in the arm is a predetermined constant value, wherein the linear model represents a linear relationship between the control current and each of the sensed current, the sensed voltage and the sensed temperature of the operation state sensing information when the voltage change rate attains the predetermined constant value.

2. The driving device of a semiconductor device according to claim 1, further comprising:

a learning unit (2a) configured to learn the linear model, wherein the calculation unit (2b) is configured to create the control current command based on the linear model learned by the learning unit.

3. The driving device of the semiconductor device according to claim 1, further comprising:

a sensing unit (1) configured to detect the operation state sensing information, wherein the calculation unit (2b) is configured to create, in accordance with the operation state sensing information detected by the sensing unit, the control current command.

4. The driving device of a semiconductor device according to claim 3, wherein the sensing unit (1) is configured to

detect an applied voltage of the semiconductor device or a power supply voltage of the power conversion device (100) as the sensed voltage, detect a current flowing in the semiconductor device or a load current as the sensed current, and detect a temperature of the semiconductor device or a temperature dependent electrical characteristic parameter TSEP of the semiconductor device as the sensed temperature.

5. The driving device of a semiconductor device according to claim 1, wherein the output unit (3) includes a plurality of switching elements connected between the control terminal and a control power supply potential, and is configured to control the control current by changing a switching element that is turned on among the plurality of switching elements.

6. The driving device of a semiconductor device according to claim 1, wherein the output unit is configured to control the control current by changing a magnitude of a control power supply potential.

7. A driving method of a semiconductor device for driving a semiconductor device (101) serving as an arm in a power conversion device (100), wherein

a control current is output to a control terminal (G) of the semiconductor device, the magnitude of the control current being controlled in accordance with a control current command, and the control current command is created, in accordance with operation state sensing information of the semiconductor device and based on a linear model, such that a magnitude of a voltage change rate of the voltage between the cathode and the anode of a reflux diode (102) in the arm during reverse recovery of the reflux diode is a predetermined constant value, the operation sensing information constituted by a sensed current flowing in the semiconductor device, a sensed voltage applied to the semiconductor device and a sensed temperature of the semiconductor device, wherein the linear model represents a linear relationship between the control current and each of the sensed current, the sensed voltage and the sensed temperature of the operation state sensing information when the voltage change rate attains the predetermined constant value.

8. A power conversion device including a pair of upper and lower arms, the power conversion device comprising:

a first semiconductor device (101a) and a first reflux diode (102a) serving as the upper arm in the pair of upper and lower arms;

a second semiconductor device (101b) and a second reflux diode (102b) serving as the lower arm in the pair of upper and lower arms;

a first driving device (104a) according to claim 1, which is configured to drive the first semiconductor device so that a magnitude of a voltage change rate of the voltage between the cathode and the anode of the second reflux diode in the lower arm during reverse recovery of the second reflux diode is a predetermined constant value, and a second driving device (104b) according to claim 1, which is configured to drive the second semiconductor device so that a magnitude of a voltage change rate of the voltage between the cathode and the anode of the first reflux diode in the upper arm during reverse recovery of the first reflux diode is a predetermined constant value.

## Patentansprüche

**1.** Ansteuerungsvorrichtung einer Halbleitervorrichtung zum Ansteuern der Halbleitervorrichtung (101), die als ein Arm in einer Stromwandlungsvorrichtung (100) dient, wobei die Ansteuerungsvorrichtung umfasst:

eine Berechnungseinheit (2b), die dazu eingerichtet ist, gemäß Betriebszustandserfassungsinformationen der Halbleitervorrichtung, einen Steuerstrombefehl zu erzeugen, wobei die Betriebserfassungsinformationen durch einen erfassten Strom, der durch die Halbleitervorrichtung fließt, eine erfasste Spannung, die an die Halbleitervorrichtung angelegt wird, und eine erfasste Temperatur der Halbleitervorrichtung gebildet werden, und eine Ausgabeeinheit (3), die dazu eingerichtet ist, einen Steuerstrom an einen Steueranschluss (G) der Halbleitervorrichtung auszugeben, indem die Größe des Steuerstroms gemäß dem Steuerstrombefehl gesteuert wird,

**gekennzeichnet dadurch, dass** die Berechnungseinheit dazu eingerichtet ist, gemäß den Betriebszustandserfassungsinformationen der Halbleitervorrichtung und basierend auf einem linearen Modell den Steuerstrombefehl derart zu erzeugen, dass eine Größe einer Spannungsänderungsrate der Spannung zwischen der Kathode und der Anode einer Rückflussdiode (102) in dem Arm während der Rückerholung der Rückflussdiode in dem Arm ein vorbestimmter konstanter Wert ist,

wobei das lineare Modell eine lineare Beziehung zwischen dem Steuerstrom und jedem des erfassten Stroms, der erfassten Spannung und der erfassten Temperatur der Betriebszustandserfassungsinformationen darstellt, wenn die Spannungsänderungsrate den vorbestimmten konstanten Wert annimmt.

**2.** Ansteuerungsvorrichtung einer Halbleitervorrichtung nach Anspruch 1, ferner umfassend:

eine Lerneinheit (2a), die dazu eingerichtet ist, das lineare Modell zu erlernen, wobei die Berechnungseinheit (2b) dazu eingerichtet ist, den Steuerstrombefehl basierend auf dem von der Lerneinheit erlernten linearen Modell zu erzeugen.

**3.** Ansteuerungsvorrichtung der Halbleitervorrichtung nach Anspruch 1, ferner umfassend:

eine Erfassungseinheit (1), die dazu eingerichtet ist, die Betriebszustandserfassungsinformationen zu detektieren,

wobei die Berechnungseinheit (2b) dazu eingerichtet ist, gemäß den von der Erfassungseinheit erfassten Betriebszustandserfassungsinformationen den Steuerstrombefehl zu erzeugen.

**4.** Ansteuerungsvorrichtung einer Halbleitervorrichtung nach Anspruch 3, wobei die Erfassungseinheit (1) dazu eingerichtet ist,

eine angelegte Spannung der Halbleitervorrichtung oder eine Stromversorgungsspannung der Stromwandlungsvorrichtung (100) als die erfasste Spannung zu detektieren,

einen Strom, der durch die Halbleitervorrichtung fließt, oder einen Laststrom als den erfassten Strom zu detektieren, und

eine Temperatur der Halbleitervorrichtung oder einen temperaturabhängigen charakteristischen elektrischen Parameter TSEP der Halbleitervorrichtung als die erfasste Temperatur zu detektieren.

**5.** Ansteuerungsvorrichtung einer Halbleitervorrichtung nach Anspruch 1, wobei die Ausgabeeinheit (3) mehrere Schaltelemente umfasst, die zwischen dem Steueranschluss und einem Steuerstromversorgungspotential verbunden sind, und dazu eingerichtet ist, den Steuerstrom durch Ändern eines Schaltelements, das eingeschaltet ist, unter den mehreren Schaltelementen, zu steuern.

6. Ansteuerungsvorrichtung einer Halbleitervorrichtung nach Anspruch 1, wobei
die Ausgabeeinheit dazu eingerichtet ist, den Steuerstrom durch Ändern einer Größe eines Steuerstromversorgungspotentials zu steuern.

7. Ansteuerungsverfahren einer Halbleitervorrichtung zum Ansteuern einer Halbleitervorrichtung (101), die als ein Arm in einer Stromwandlungsvorrichtung (100) dient, wobei

ein Steuerstrom an einen Steueranschluss (G) des Halbleitervorrichtung ausgegeben wird, wobei die Größe des Steuerstroms gemäß einem Steuerstrombefehl gesteuert wird, und
der Steuerstrombefehl gemäß Betriebszustandserfassungsinformationen der Halbleitervorrichtung und basierend auf einem linearen Modell derart erzeugt wird, dass eine Größe einer Spannungsänderungsrate der Spannung zwischen der Kathode und der Anode einer Rückflussdiode (102) in dem Arm während der Rückerholung der Rückflussdiode ein vorbestimmter konstanter Wert ist, wobei die Betriebserfassungsinformationen durch einen erfassten Strom, der durch die Halbleitervorrichtung fließt, eine erfasste Spannung, die an die Halbleitervorrichtung angelegt wird, und eine erfasste Temperatur der Halbleitervorrichtung gebildet werden, wobei das lineare Modell eine lineare Beziehung zwischen dem Steuerstrom und jedem des erfassten Stroms, der erfassten Spannung und der erfassten Temperatur der Betriebszustandserfassungsinformationen darstellt, wenn die Spannungsänderungsrate den vorbestimmten konstanten Wert annimmt.

8. Stromwandlungsvorrichtung, die ein Paar oberer und unterer Arme enthält, wobei die Stromwandlungsvorrichtung umfasst:

eine erste Halbleitervorrichtung (101a) und eine erste Rückflussdiode (102a), die als der obere Arm in dem Paar oberer und unterer Arme dienen;
eine zweite Halbleitervorrichtung (101b) und eine zweite Rückflussdiode (102b), die als der untere Arm in dem Paar oberer und unterer Arme dienen;
eine erste Ansteuerungsvorrichtung (104a) nach Anspruch 1, die dazu eingerichtet ist, die erste Halbleitervorrichtung so anzusteuern, dass eine Größe einer Spannungsänderungsrate der Spannung zwischen der Kathode und der Anode der zweiten Rückflussdiode in dem unteren Arm während der Rückerholung der zweiten Rückflussdiode ein vorbestimmter konstanter Wert ist, und
eine zweite Ansteuerungsvorrichtung (104b) nach Anspruch 1, die dazu eingerichtet ist, die zweite Halbleitervorrichtung so anzusteuern, dass eine Größe einer Spannungsänderungsrate der Spannung zwischen der Kathode und der Anode der ersten Rückflussdiode in dem oberen Arm während der Rückerholung der ersten Rückflussdiode ein vorbestimmter konstanter Wert ist.

## Revendications

1. Dispositif d'entraînement d'un dispositif à semi-conducteur pour entraîner le dispositif (101) à semi-conducteur servant comme un bras dans un dispositif (100) de conversion de puissance, le dispositif d'entraînement comprenant :

une unité (2b) de calcul configurée pour créer, conformément à des informations de détection d'état de fonctionnement du dispositif à semi-conducteur, une commande de courant de commande, les informations de détection de fonctionnement constituées par un courant détecté passant dans le dispositif à semi-conducteur, une tension détectée appliquée au dispositif à semi-conducteur et une température détectée du dispositif à semi-conducteur, et
une unité (3) de sortie configurée pour délivrer en sortie un courant de commande jusqu'à une borne (G) de commande du dispositif à semi-conducteur en commandant la grandeur du courant de commande conformément à la commande de courant de commande,
**caractérisé en ce que** l'unité de calcul est configurée pour créer, conformément aux informations de détection d'état de fonctionnement du dispositif à semi-conducteur et sur la base d'un modèle linéaire, la commande de courant de commande de telle façon qu'une grandeur d'un taux de changement de tension de la tension entre la cathode et l'anode d'une diode à reflux (102) dans le bras lors d'une récupération inverse de la diode à reflux dans le bras est une valeur constante prédéterminée,
dans lequel le modèle linéaire représente une relation linéaire entre le courant de commande et chacun(e) du courant détecté, de la tension détectée et de la température détectée des informations de détection d'état de fonctionnement lorsque le taux de changement de tension atteint la valeur constante prédéterminée.

2. Dispositif d'entraînement d'un dispositif à semi-conducteur selon la revendication 1, comprenant en outre :

une unité (2a) d'apprentissage configurée pour apprendre le modèle linéaire,
dans lequel l'unité (2b) de calcul est configurée pour créer la commande de courant de commande sur la base du modèle linéaire appris par l'unité d'apprentissage.

3. Dispositif d'entraînement d'un dispositif à semi-conducteur selon la revendication 1, comprenant en outre :

une unité (1) de détection configurée pour détecter les informations de détection d'état de fonctionnement,
dans lequel l'unité (2b) de calcul est configurée pour créer, conformément aux informations de détection d'état de fonctionnement détectées par l'unité de détection, la commande de courant de commande.

4. Dispositif d'entraînement d'un dispositif à semi-conducteur selon la revendication 3, dans lequel l'unité (1) de détection est configurée pour

détecter une tension appliquée du dispositif à semi-conducteur ou une tension d'alimentation électrique du dispositif (100) de conversion de puissance comme la tension détectée,
détecter un courant passant dans le dispositif à semi-conducteur ou un courant de charge comme le courant détecté, et
détecter une température du dispositif à semi-conducteur ou un paramètre électrique caractéristique dépendant de la température **TSEP** du dispositif à semi-conducteur comme la température détectée.

5. Dispositif d'entraînement d'un dispositif à semi-conducteur selon la revendication 1, dans lequel
l'unité (3) de sortie inclut une pluralité d'éléments de commutation connectés entre la borne de commande et un potentiel d'alimentation de commande, et est configurée pour commander le courant de commande en changeant un élément de commutation qui est activé parmi la pluralité d'éléments de commutation.

6. Dispositif d'entraînement d'un dispositif à semi-conducteur selon la revendication 1, dans lequel
l'unité de sortie est configurée pour commander le courant de commande en changeant une grandeur du potentiel d'alimentation de commande.

7. Procédé d'entraînement d'un dispositif à semi-conducteur pour entraîner un dispositif (101) à semi-conducteur servant comme un bras dans un dispositif (100) de conversion de puissance, dans lequel

un courant de commande est délivré en sortie jusqu'à une borne (G) de commande du dispositif à semi-conducteur, la grandeur du courant de commande étant commandée conformément à une commande de courant de commande, et
la commande de courant de commande est créée, conformément à des informations de détection d'état de fonctionnement du dispositif à semi-conducteur et sur la base d'un modèle linéaire, de telle façon qu'une grandeur d'un taux de changement de tension de la tension entre la cathode et l'anode d'une diode à reflux (102) dans le bras lors d'une récupération inverse de la diode à reflux est une valeur constante prédéterminée, les informations de détection de fonctionnement constituées par un courant détecté passant dans le dispositif à semi-conducteur, une tension détectée appliquée au dispositif à semi-conducteur et une température détectée du dispositif à semi-conducteur,
dans lequel le modèle linéaire représente une relation linéaire entre le courant de commande et chacun(e) du courant détecté, de la tension détectée et de la température détectée des informations de détection d'état de fonctionnement lorsque le taux de changement de tension atteint la valeur constante prédéterminée.

8. Dispositif de conversion de puissance incluant une paire de bras supérieur et inférieur, le dispositif de conversion de puissance comprenant :

un premier dispositif (101a) à semi-conducteur et une première diode à reflux (102a) servant comme le bras supérieur dans la paire de bras supérieur et inférieur ;
un deuxième dispositif (101b) à semi-conducteur et une deuxième diode à reflux (102b) servant comme le bras inférieur dans la paire de bras supérieur et inférieur ;
un premier dispositif (104a) d'entraînement selon la revendication 1, qui est configuré pour entraîner le premier dispositif à semi-conducteur de telle façon qu'une grandeur d'un taux de changement de tension de la tension entre la cathode et l'anode de la deuxième diode à reflux dans le bras inférieur lors d'une récupération inverse de la deuxième diode à reflux est une valeur constante prédéterminée, et

un deuxième dispositif (104b) d'entraînement selon la revendication 1, qui est configuré pour entraîner le deuxième dispositif à semi-conducteur de telle façon qu'une grandeur d'un taux de changement de tension de la tension entre la cathode et l'anode de la première diode à reflux dans le bras supérieur lors d'une récupération inverse de la première diode à reflux est une valeur constante prédéterminée.

# FIG. 1

# FIG. 2

# FIG. 3

START

S101 — SET OPERATING CONDITIONS
TO BE CONSTANT
VOLTAGE : V, CURRENT : I,
TEMPERATURE T

S102 — SPECIFY GATE CURRENT
GATE CURRENT : $I_g^*$

S103 — CALCULATE SWITCHING LOSS
AND VOLTAGE CHANGE RATE
SWITCHING LOSS : E
VOLTAGE CHANGE RATE : dv/dt

S104 — dv/dt = CONTROL
TARGET VALUE ?    NO

YES

S105 — SET OPTIMUM GATE CURRENT
GATE CURRENT : $I_g$

S106 — ACQUIRE LEARNING DATA
LEARNING DATA : [y X]

S107 — LEARN LINEAR MODEL
LINEAR MODEL : $y = X^* \theta$

S108 — DRIVE IGBT AT
OPTIMUM GATE CURRENT

# FIG. 4

# FIG. 5

V, I, T : CONSTANT
$I_g$ : PARAMETER

VOLTAGE CHANGE RATE : dv/dt

$I_g*1$

$I_g*2$

dv/dt(CONTROL TARGET VALUE)

$I_g*3$

$I_g*4$

SWITCHING LOSS : E

## FIG. 6

## FIG. 7

# FIG. 8

**EP 3 820 046 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009027881 A

- US 2003107905 A1